Europäisches Patentamt

(19) European Patent Office

Office européen des brevets

(11) Numéro de publication: **0 350 121**

**A1**

(12) **DEMANDE DE BREVET EUROPEEN**

(21) Numéro de dépôt: 89201753.4

(22) Date de dépôt: 03.07.89

(51) Int. Cl.⁴: **G06F 15/68**

(30) Priorité: 08.07.88 FR 8809293

(43) Date de publication de la demande:
**10.01.90 Bulletin 90/02**

(84) Etats contractants désignés:
**DE FR GB SE**

(71) Demandeur: **LABORATOIRES D'ELECTRONIQUE ET DE PHYSIQUE APPLIQUEE L.E.P.**
**3, Avenue Descartes**
**F-94450 Limeil-Brévannes(FR)**

(84) **FR**

Demandeur: **N.V. Philips' Gloeilampenfabrieken**
**Groenewoudseweg 1**
**NL-5621 BA Eindhoven(NL)**

(84) **DE GB SE**

(72) Inventeur: **Mathieu, Yves Société Civile S.P.I.D.**
**209, rue de l'Université**
**F-75007 Paris(FR)**
Inventeur: **Martin, Philippe Société Civile S.P.I.D.**
**209, rue de l'Université**
**F-75007 Paris(FR)**

(74) Mandataire: **Landousy, Christian et al Société Civile S.P.I.D. 209, Rue de l'Université**
**F-75007 Paris(FR)**

(54) **Circuit intégré et dispositif de traitement d'images.**

(57) Circuit intégré de traitement de signaux numérisés représentatifs d'une image source définie par des éléments d'image, codés sur M bits, disposés selon I lignes et J colonnes. Le traitement de l'image s'opère à l'aide de S fenêtres glissantes ($W_1$ à $W_S$) de N lignes et de P colonnes qui glissent pas à pas à chaque élément d'image le long des I lignes mais décalées les unes des autres d'une ligne. Le traitement est effectué par des opérateurs série agissant successivement sur chaque bit de chacun de $N+S-1$ éléments d'image. Les si gnaux peuvent être introduits en série à l'aide de Q plots de contact où $Q = N+S-1$ ou en parallèle à l'aide de Q plots de contact où Q est le premier multiple de M qui égale ou sinon majore $N+S-1$, le circuit intégré comprenant alors en outre un circuit de transformation parallèle/série.

FIG.2A

## Circuit intégré et dispositif de traitement d'images

L'invention concerne un circuit intégré de traitement de signaux numérisés représentatifs d'une image source définie par des éléments d'image, codés sur M bits, disposés selon I lignes et J colonnes, le traitement de cette image source s'opérant en prélevant pas à pas des images locales délimitées par une fenêtre N.P de N lignes et de P colonnes, avec N>1, qui glisse pas à pas à chaque élément d'image le long des I lignes de l'image source pour couvrir l'ensemble des configurations pour lesquelles la fenêtre ne s'étend pas à l'extérieur de l'image source. Elle concerne également un dispositif de traitement d'images.

Une invention de ce genre est connue du document US 4 550 437 qui décrit un appareillage pour le traitement parallèle de données d'images locales. Le but qui y est poursuivi est de concevoir un circuit intégré à grande échelle d'intégration effectuant des opérations de convolution pour le traitement d'images (élimination du bruit, détection des contours, ...). Les difficultés rencontrées concernent la grande densité d'intégration et le nombre élevé de plots de connexion que doit posséder le circuit intégré. Le traitement consiste à délimiter une image locale, prise dans l'image globale à l'aide d'une fenêtre, et comportant m rangées de n éléments. Le circuit intégré décrit comporte 4 rangées de 4 éléments qui sont traités par 4 mémoires et 4 processeurs pour le traitement d'une fenêtre 4x4. Les bits d'un élément d'image sont introduits en parallèle dans le premier étage, traités puis décalés vers le processeur suivant et ainsi de suite puis tous les résultats sont additionnés pour délivrer le résultat recherché. Mais lorsque la taille de la fenêtre est de plus grandes dimensions, la réalisation d'un circuit intégré où les bits sont introduits en parallèle devient vite insurmontable à réaliser par le nombre de connexions vers l'extérieur.

De plus rien n'est indiqué sur la manière de réaliser les circuits de retard, et à plus forte raison sur leur intégration, opérant sur un tel nombre de données qui doivent être présentes simultanément sur les plots de contact d'entrée.

Dans le cas d'un traitement parallèle à fenêtres glissantes, supposons une fenêtre W(i) se déplaçant horizontalement dans l'image à traiter et supposons que l'on dispose d'une structure de traitement permettant de calculer la fonction voulue à chaque cycle f(W(i)). A chaque cycle, la fenêtre se décale d'une position vers la droite ce qui oblige à introduire N données nouvelles dans la structure de traitement. Par exemple pour une fenêtre 9x9 et un codage des données sur 8 bits, 72 données nouvelles doivent être introduites et 9 retards d'une ligne doivent être utilisés pour accéder aux 9 lignes consécutives. On arrive donc à des circuits possédant un grand nombre de connexions d'entrée.

Le problème posé par l'invention est celui de la réalisation de circuits intégrés de traitement de données numériques à partir d'une fenêtre glissante qui réduit à un minimum le nombre de connexions vers l'extérieur. Selon un premier mode de réalisation la solution à ce problème posé consiste en ce que le traitement est effectué simultanément sur S images locales délimitées par S fenêtres glissantes ayant toutes les mêmes dimensions mais décalées les unes des autres de "d" lignes de l'image source, avec $1 \leq d \leq N-1$, et lorsque les S fenêtres glissantes ont atteint la fin de leurs lignes respectives, elles se déplacent toutes en bloc pour recommencer le même traitement, ce traitement étant effectué par des opérateurs série agissant successivement sur chaque bit de chacun de $N+(S-1)d$ éléments d'image dont les signaux numérisés sont introduits en série dans le circuit intégré à l'aide de Q plots de contact, où Q est égal au nombre de lignes traitées en combinaison par les S images locales, chacun des Q plots de contact recevant les signaux numérisés en provenance d'un élément d'image déterminé.

Préférentiellement le nombre S de fenêtres glissantes est égal au nombre M de bits des éléments d'images (S = M) et le décalage d est égal à une ligne. C'est cette situation qui sera développée à titre d'exemple dans la description. Les valeurs de M et de d peuvent être choisies indépendamment. Lorsque le décalage d n'est pas égal à une ligne, une procédure d'exploration de toutes les lignes doit être opérée, par exemple par entrelacement, pour conserver la totalité de l'information.

Le circuit intégré met en oeuvre un traitement de type série pipeline en utilisant des processeurs 1 bit. La surface de circuit intégré nécessaire est alors approximativement divisée par un nombre M égal à la taille des mots des données traitées, mais également la vitesse de calcul est ainsi divisée par M. Pour pouvoir conserver une vitesse de traitement nécessaire compatible avec un traitement en temps réel, on traite selon l'exemple M fenêtres en parallèle. Approximativement la surface d'un tel circuit intégré est semblable à celle du processeur parallèle mais par contre le nombre de fils de connexion est différent. En effet pour un dispositif traitant une fenêtre de N lignes il faut N signaux d'entrée de M bits. Avec M processeurs travaillant sur des fenêtres décalées d'une ligne les unes par rapport aux autres, il suffit de N+M-1 lignes d'entrée. Chaque processeur partage N-1 lignes avec le précédent. Le gain devient tout à fait significatif même pour des valeurs de M et N pas très élevées. Ainsi avec une fenêtre de 9x9 (N = 9) et des mots de 8 bits (M = 8), un processeur parallèle nécessite 72 plots de contact et le processeur série de l'invention en nécessite seulement 16.

Mais l'invention ne se limite pas au cas de l'introduction en série des données sur les plots de contact. Il est en effet possible de conserver l'introduction en parallèle des données, à l'aide d'un nombre réduit de plots de contact, puis d'effectuer une transformation interne parallèle/série afin de permettre le même fonctionnement des opérateurs série que précédemment.

Pour cela selon un deuxième mode de réalisation le traitement est effectué simultanément sur S images locales délimitées par S fenêtres glissantes ayant toutes les mêmes dimensions mais décalées les unes des autres de d lignes de l'image source, avec $1 \leq d \leq N-1$, et lorsque les S fenêtres glissantes ont atteint la fin de leurs lignes respectives, elles se déplacent toutes en bloc pour recommencer le même traitement, ce traitement étant effectué par des opérateurs série agissant successivement sur chaque bit de chacun de $N+(S-1)d$ éléments d'image dont les signaux numérisés sont introduits en parallèle dans le circuit intégré à l'aide de Q plots de contact où Q est le premier multiple de M qui égale ou sinon majore $N+(S-1)d$, le circuit intégré comprenant en outre un circuit de transformation parallèle/série. De même que dans le premier mode de réalisation, préférentiellement $S=M$ et $d=1$ ligne.

Les opérateurs série peuvent réaliser différentes opérations sur des données numériques pour lesquelles le traitement consiste à exploiter simultanément les données locales définies par une fenêtre. Il peut s'agir d'un traitement d'images, par exemple des opérations de filtrage (convolution), des opérations de tri, ou des déterminations de maximum/minimum dans un lot de données déterminé, ou d'autres opérations.

Les figures suivantes données à titre d'exemple non limitatif illustrent quelques-uns de ces cas mais l'invention concerne également d'autres opérations que l'homme du métier peut aisément mettre en oeuvre.

Figure 1 : un schéma général d'un système de traitement utilisant un circuit intégré de traitement selon l'invention.

Figure 2A, 2B : des représentations de plusieurs fenêtres superposées sur une image.

Figure 3 : un schéma concernant un exemple de traitement utilisant 4 modules opérant sur des fenêtres de 5 lignes.

Figure 4A : un schéma d'un circuit de transformation de données parallèle en données série.

Figures 4B, 4C : deux schémas d'organisation possible de la mémoire d'images.

Figure 5 : un schéma d'un premier exemple de réalisation destiné à effectuer des opérations de convolution.

Figure 6 : un schéma d'un deuxième exemple de réalisation destiné à effectuer des opérations de tri.

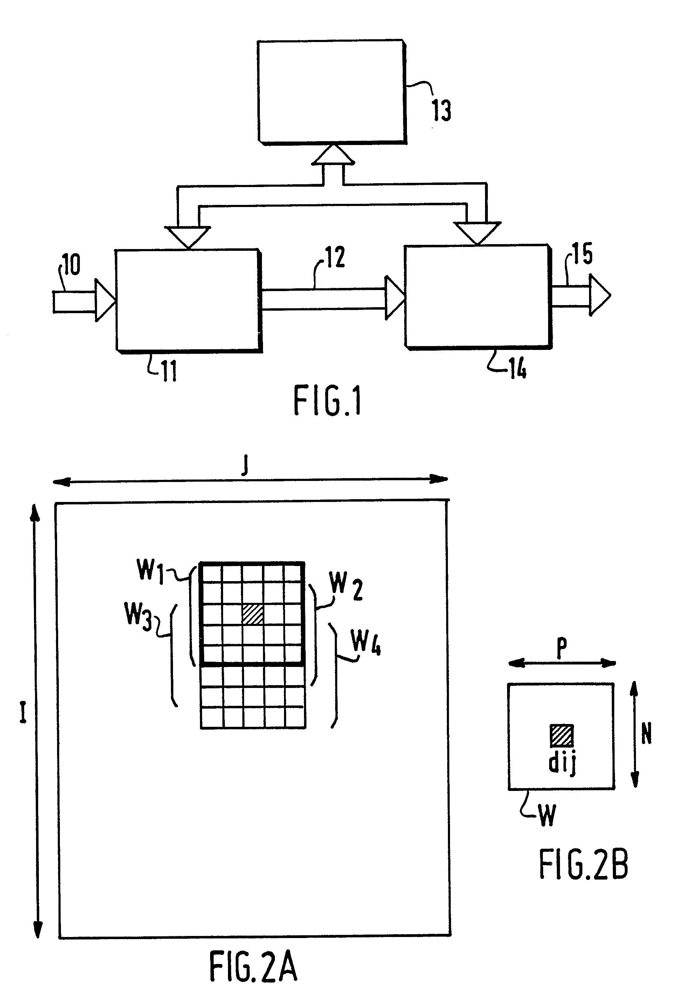

La figure 1 représente un dispositif de traitement qui comprend une mémoire d'images 11 qui reçoit les données venant du bus 10 soit à partir d'une caméra soit de tout autre dispositif ayant déjà traité des images (non représentés). Un processeur de contrôle 13 génère les adresses pour la lecture de la mémoire 11 et un circuit intégré de traitement 14 génère pour chaque point en provenance de la mémoire 11 un résultat qui est fonction du voisinage de ce point. Ce résultat sort sur le bus 15 pour une exploitation ultérieure.

La mémoire d'image (figure 2A) est une matrice de I.J points caractérisés chacun par une valeur notée $d_{ij}$ au point $d_{ij}$ où i représente la ligne et j la colonne. Ces valeurs sont codées sur M bits (typiquement $M=8$), le poids de niveau m du point $d_{ij}$ sera noté $d^m_{ij}$. Le dispositif de traitement opère sur une fenêtre rectangulaire centrée en $d_{ij}$ qui a N lignes et P colonnes (figure 2B). La valeur calculée sera $g_{ij} = f(d_{i+n,j+p})$ où n est compris entre $-N/2$ et $N/2$ et où p est compris entre $-P/2$ et $P/2$.

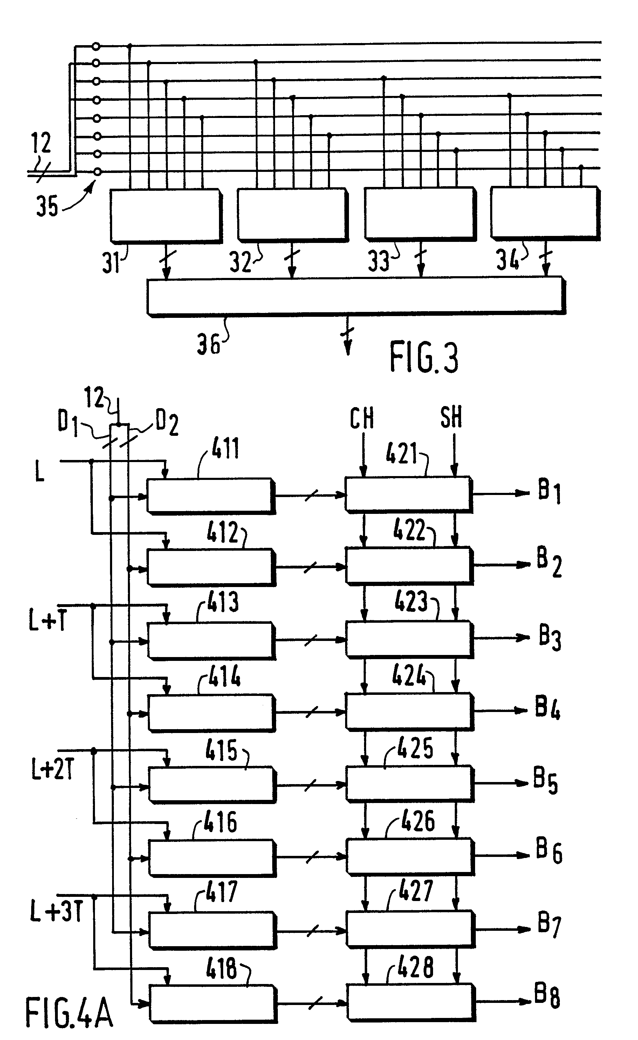

A titre d'exemple la figure 2A représente une fenêtre de 5x5 ($N=P=5$). Selon l'invention si une donnée est codée sur M bits (par exemple $M=4$) le fait d'entrer les données en mode série va réduire la vitesse de traitement d'un facteur $M=4$. Pour conserver la même vitesse de traitement, selon l'invention, on utilise alors 4 fenêtres : W1, W2, W3 et W4. A l'intérieur du circuit intégré chaque colonne d'une fenêtre va être traitée respectivement par un module 31, 32, 33, 34 (figure 3). Le bus de données 12 possède $N+M-1=8$ plots de contact 35 dans cet exemple. Le bus reçoit simultanément les 8 données de 8 lignes d'images lorsque les données entrent en série, et 8 données de 2 lignes d'images lorsque les données entrent en parallèle. En mode série le module 31 reçoit les données de la première à la cinquième ligne.
- Le module 32 reçoit les données de la deuxième à la sixième ligne.
- Le module 33 reçoit les données de la troisième à la septième ligne.
- Le module 34 reçoit les données de la quatrième à la huitième ligne.

Les résultats des 4 modules sont sélectionnés par le bloc 36 pour fournir le résultat du traitement opéré. Chaque donnée étant introduite en série, il est nécessaire d'attendre au début que toutes les données soient entrées avant d'obtenir le premier résultat, mais ensuite le flux des données est constant. Lorsque le traitement des 4 lignes de l'image source est terminé les fenêtres sont décalées en bloc de 4 lignes, la fenêtre W1 par exemple s'étend alors de la cinquième ligne à la huitième ligne et de même pour les autres fenêtres décalées.

3

Les données telles qu'elles apparaissent sur les plots de contact sont représentées sur le tableau 1 pour le mode série.

| Plots | $T_1$ | $T_2$ | $T_3$ | $T_4$ | $T_5$ | $T_6$ | |
|---|---|---|---|---|---|---|---|
| 1 | $d_{11}^1$ | $d_{11}^2$ | $d_{11}^3$ | $d_{11}^4$ | $d_{12}^1$ | $d_{12}^2$ | . . . |
| 2 | $d_{21}^1$ | $d_{21}^2$ | $d_{21}^3$ | $d_{21}^4$ | $d_{22}^1$ | $d_{22}^2$ | |
| 3 | $d_{31}^1$ | $d_{31}^2$ | $d_{31}^3$ | $d_{31}^4$ | $d_{32}^1$ | $d_{32}^2$ | |
| 4 | $d_{41}^1$ | $d_{41}^2$ | $d_{41}^3$ | $d_{41}^4$ | $d_{42}^1$ | $d_{42}^2$ | |
| 5 | $d_{51}^1$ | $d_{51}^2$ | $d_{51}^3$ | $d_{51}^4$ | $d_{52}^1$ | $d_{52}^2$ | |
| 6 | $d_{61}^1$ | $d_{61}^2$ | $d_{61}^3$ | $d_{61}^4$ | $d_{62}^1$ | $d_{62}^2$ | |
| 7 | $d_{71}^1$ | $d_{71}^2$ | $d_{71}^3$ | $d_{71}^4$ | $d_{72}^1$ | $d_{72}^2$ | |
| 8 | $d_{81}^1$ | $d_{81}^2$ | $d_{81}^3$ | $d_{81}^4$ | $d_{82}^1$ | $d_{82}^2$ | . . . |

**TABLEAU 1**

On constate par exemple que sur le plot 1 les données de l'élément d'image $d_{11}$ entrent au cours des temps $T_1$, $T_2$, $T_3$ et $T_4$.

Le traitement est effectué pour toutes les fenêtres qui ne s'étendent pas à l'extérieur de l'image source. Sur la périphérie, le traitement n'est pas appliqué ou l'est en entrant des données fictives.

Le schéma de la figure 4A permet avec un nombre réduit de plots de contact d'entrer les données en mode parallèle et de les traiter en mode série par des opérateurs à 1 bit. Pour entrer les 4 données de 4 bits relatives à une colonne, on entre en parallèle les 4 bits de 2 données qui peuvent être lues simultanément :

1ère donnée : $d_{11}^1$ à $d_{11}^4$ (entrée $D_1$)

2ème donnée : $d_{21}^1$ à $d_{21}^4$ (entrée $D_2$)

Celles-ci sont chargées en parallèle respectivement dans les registres 411 et 412 sur une même commande L. Au coup d'horloge suivant L + T on entre deux autres données :

3ème donnée : $d_{31}^1$ à $d_{31}^4$ (entrée $D_1$)

4ème donnée : $d_{41}^1$ à $d_{41}^4$ (entrée $D_2$)

Elles sont chargées en parallèle dans les registres 413 et 414.

On fait de même pour les 4 autres données sur les commandes L + 2T et L + 3T. Ainsi après 4 coups d'horloge, les 8 données de 4 bits sont chargées dans les registres 411 à 418. Elles sont alors chargées ensemble respectivement dans les registres 421 à 428 par la commande commune CH. Ces registres sont chargés en parallèle et lus en série à l'aide de la commande commune de décalage SH. Ainsi à l'aide des 8 plots de contact les données sont entrées en parallèles mais néanmoins utilisées en mode série pour être exploitées par les opérateurs 1 bit suivants. Ainsi les bits de poids identique sont successivement présents sur les sorties $B_1$ à $B_8$ pour les 8 éléments d'image.

4

Les données telles qu'elles apparaîssent sur les plots de contact sont représentées sur le tableau 2 pour le mode parallèle.

| Plots | $T_1$ | $T_2$ | $T_3$ | $T_4$ | $T_5$ | $T_6$ | |
|---|---|---|---|---|---|---|---|
| 1 | $d_{11}^1$ | $d_{31}^1$ | $d_{51}^1$ | $d_{71}^1$ | $d_{12}^1$ | $d_{32}^1$ | ... |
| 2 | $d_{11}^2$ | $d_{31}^2$ | $d_{51}^2$ | $d_{71}^2$ | $d_{12}^2$ | $d_{32}^2$ | |
| 3 | $d_{11}^3$ | $d_{31}^3$ | $d_{51}^3$ | $d_{71}^3$ | $d_{12}^3$ | $d_{32}^3$ | |
| 4 | $d_{11}^4$ | $d_{31}^4$ | $d_{51}^4$ | $d_{71}^4$ | $d_{12}^4$ | $d_{32}^4$ | |
| 5 | $d_{21}^1$ | $d_{41}^1$ | $d_{61}^1$ | $d_{81}^1$ | $d_{22}^1$ | $d_{42}^1$ | ... |
| 6 | $d_{21}^2$ | $d_{41}^2$ | $d_{61}^2$ | $d_{81}^2$ | $d_{22}^2$ | $d_{42}^2$ | |
| 7 | $d_{21}^3$ | $d_{41}^3$ | $d_{61}^3$ | $d_{81}^3$ | $d_{22}^3$ | $d_{42}^3$ | |
| 8 | $d_{21}^4$ | $d_{41}^4$ | $d_{61}^4$ | $d_{81}^4$ | $d_{22}^4$ | $d_{42}^4$ | |

**TABLEAU 2**

On constate par exemple que les données de l'élément d'image $d_{11}$ entrent sur les plots de contact numéro 1, 2, 3 et 4 et que simultanément les données de l'élément d'image $d_{21}$ entrent sur les plots de contact numéro 5, 6, 7 et 8.

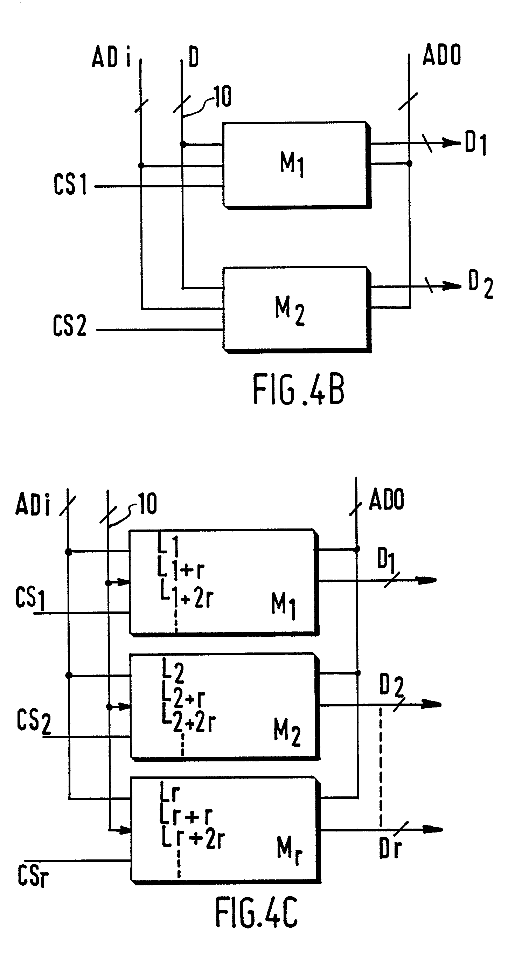

Les figures 4B et 4C fournissent un exemple de schéma d'organisation de la mémoire d'images afin de pouvoir lire simultanément les données $D_1$ et $D_2$. La mémoire d'images 11 de la figure 1 se subdivise alors en deux mémoires $M_1$ et $M_2$ (figure 4B), l'une recevant les lignes paires et l'autre les lignes impaires. La totalité des données D arrivent sur le bus 10. Deux signaux de sélection CS1 et CS2 permettent de sélectionner respectivement $M_1$ et $M_2$. Elles utilisent ainsi le même bus d'adressage d'entrée ADI et le même bus d'adressage de sortie ADO. Ces deux bus peuvent avoir des flux instantanés différents, mais les flux globaux sur la totalité d'une trame sont égaux afin de permettre un fonctionnement en temps réel. Les données $D_1$ et $D_2$ sont ainsi séparées afin de permettre leur lecture pour être introduites en entrée du schéma de la figure 4A. Cette situation correspond au cas où N + M-1 est inférieur ou égal à 2M (figure 4B).

Dans le cas général pour entrer les données en parallèle, le nombre Q de plots de contact sera le premier multiple de M qui majore N + M-1, c'est-à-dire lorsque N + M-1 est inférieur ou égal à r.M où r est un nombre entier positif. D' autre part lorsque les données sont entrées en série on a Q = N + M-1. En conséquence il existe des situations où le nombre Q sera le même dans le cas série et dans le cas parallèle. Ces situations sont repérées par un astéristique dans le tableau 3 qui donne quelque exemples dans des cas simples.

TABLEAU 3

|   | M = 4 | M = 8 |
|---|-------|-------|
| N | Q | Q |
| 2 | 8 | 16 |
| 3 | 8 | 16 |
| 4 | 8 | 16 |
| 5 | 8* | 16 |
| 6 | 12 | 16 |
| 7 | 12 | 16 |
| 8 | 12 | 16 |
| 9 | 12* | 16* |
| 10 | 16 | 24 |
| 11 | 16 | 24 |
| 12 | 16 | 24 |
| 13 | 16* | 24 |

Pour traiter le cas général où Q est inférieur ou égal à r.M, l'organisation de la mémoire peut être celle représentée par le schéma de la figure 4C pour former avec le circuit intégré de traitement un dispositif de traitement d'images. La mémoire d'images est alors organisée en r blocs mémoire $M_1$, $M_2$ ... $M_r$. Le fonctionnement est semblable à celui décrit pour la figure 4B, mais au lieu d'obtenir en $D_1$ les données des lignes paires seulement (par exemple), on obtient les données de toutes les r lignes (modulo r). Il est alors nécessaire d'adapter le schéma de la figure 4A pour charger et lire r registres au lieu de 2. Ainsi l'invention concerne également un dispositif de traitement d'images qui comprend r mémoires d'images (avec Q = r.M) qui délivrent les données d'entrée.

Les modes de traitement série et parallèle viennent d'être décrits avec S = M et d = 1. Dans le cas plus général où S≠M et d≠1, le nombre de données nouvelles d'une colonne est alors égal à N + (S-1)d.

Les données qu'elles soient introduites en mode série ou en mode parallèle sont exploitées à l'intérieur du circuit intégré par des opérateurs série pour effectuer un traitement selon lequel un élément d'image d'arrivée est une fonction d'un voisinage (délimité par la fenêtre) d'un élément d'image de l'image source.

Le flux des données en entrée de la mémoire d'image est incompressible. En conséquence le flux de données en entrée du circuit est identique sur une période de durée longue par exemple une trame. Pour des durées plus brèves, par exemple pour une ligne de mémoire d'image, ce flux doit être le plus proche possible du flux d'entrée dans la mémoire d'image afin d'éviter à avoir à générer des organisations mémoire compliquées.

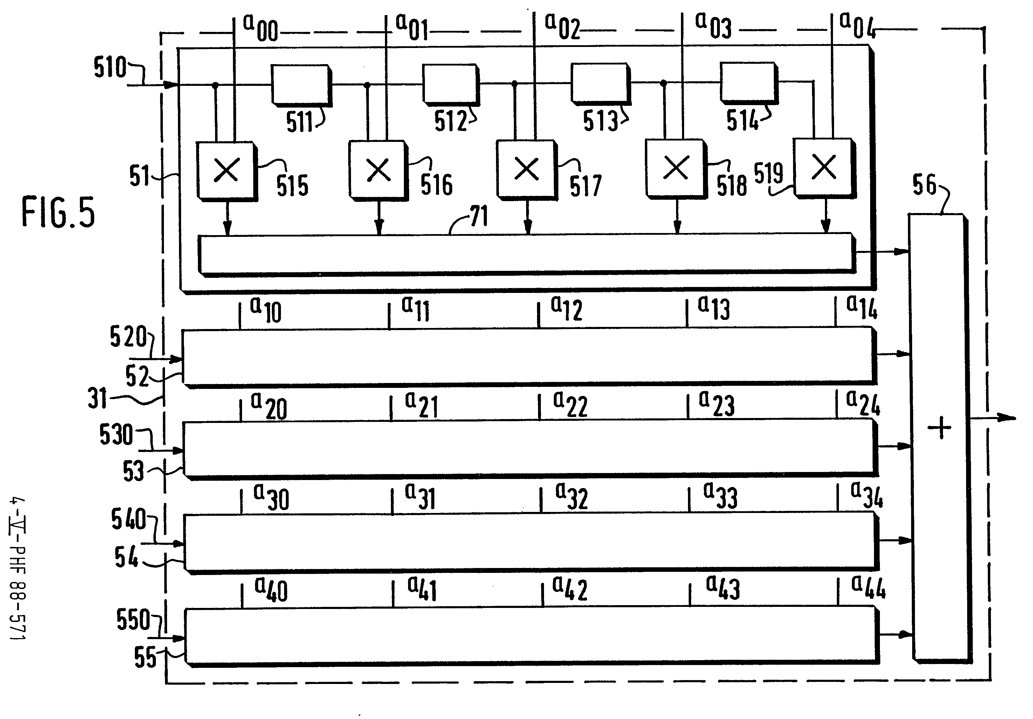

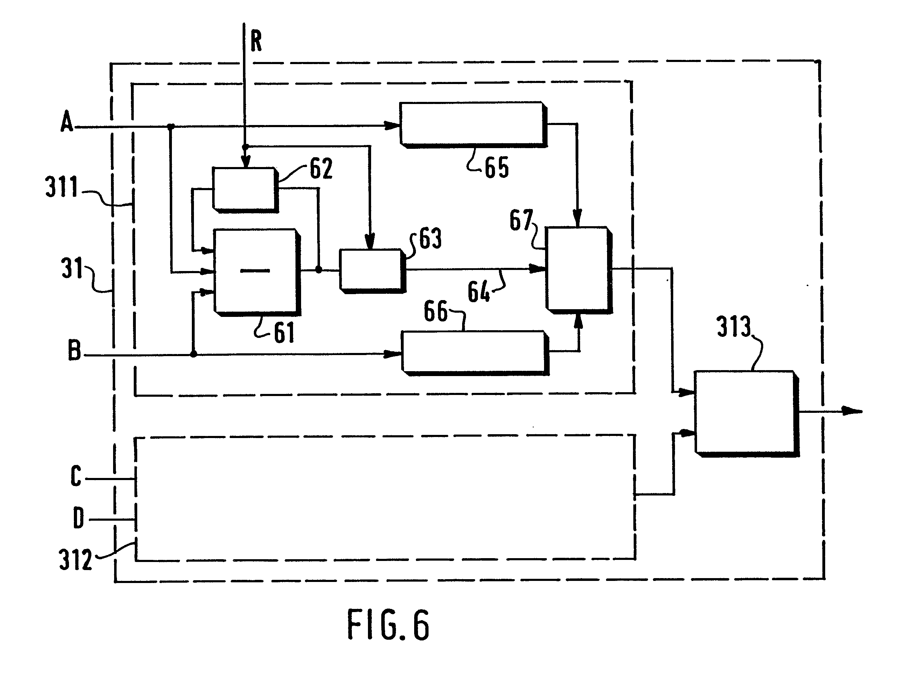

A titre d'exemple deux types différents de traitement sont représentés sur les figures 5 et 6.

La figure 5 donne un exemple de traitement dans le cas où la fonction choisie est la convolution :
$$g_{i,j} = \text{Somme de } a_{n,p}.d_{i+n,j+p}$$
Pour une fenêtre 5.5, le convolueur 31 est composé de N = 5 unités 51, 52, 53, 54, 55 connectées respectivement aux entrées 510, 520, 530, 540 et 550. Les 5 unités sont de conception identique. Leurs sorties sont réunies à l'arbre d'additionneurs 56 qui délivre le résultat du module convolueur 31. Chaque unité, par exemple l'unité 51, comprend P-1 = 4 registres à décalage 511, 512, 513, 514 retardant les données de 4 coups d'horloge (M = 4 bits) permettant de présenter les données série à multiplier sur les entrées de P = 5 multiplieurs pipeline série 515, 516, 517, 518 et 519. Chaque multiplieur calcule le produit d'un coefficient $a_{np}$ avec la donnée présente sur son entrée. Un tel multiplieur série est par exemple celui décrit dans "On a bit-serial input and bit-serial output multiplier" par R. GNANASEKARAN IEEE Transactions on Computer Vol C32 n° 9, septembre 1983. Les résultats en sortie des multiplieurs sont additionnés dans un arbre d'additionneurs série 71. Toutes les unités 51, 52, 53, 54 et 55 reçoivent leurs propres données et leurs propres coefficients. Les résultats en sortie de ces unités sont additionnés dans l'arbre d'additionneurs 56. Pour l'ensemble du traitement sur 4 fenêtres il est nécessaire de réaliser 4 modules convolueurs, tels que le module 31, qui partagent un certain nombre de ressources :

- la mémoire des coefficients $a_{np}$ est commune
- les registres à décalage qui traitent les lignes communes à plusieurs fenêtres peuvent être communs afin de réduire la surface du circuit intégré.

Ainsi les opérateurs série effectuent une convolution entre les signaux numérisés des éléments des images locales et une matrice de N.P coefficients stockés dans une mémoire.

La figure 6 concerne un deuxième exemple pour lequel le traitement consiste à déterminer le tri par exemple le minimum ou le maximum des valeurs dans la fenêtre courante tel que :

$$g_{i,j} = Min/Max (d_{i+n,j+p})$$

où n est compris entre -N/2 et N/2 et où p est compris entre -P/2 et P/2.

La fenêtre a dans cet exemple 4 lignes et 4 colonnes . Les données entrent de manière série bit à bit en commençant par le poids faible sur les entrées A, B, C et D. Pour le couple A, B (bloc 311) un soustracteur 1 bit 61 couplé à un registre de mémorisation de retenue 62 permet de calculer le signe de la différence des données entrant en A et B en 4 coups d'horloge (M = 4 bits). Ce registre 62 est remis à zéro par un signal R à l'instant où le bit de poids faible est présenté en A et B. Ce signal R déclenche en même temps l'introduction du bit de signe dans le registre 63 qui mémorise ce signe. Deux registres à décalage 65, 66 de longueur M = 4 bits, retardent respectivement les données A et B. La sortie 64 du registre 63 commande un multiplexeur 67 permettant de choisir le minimum ou le maximum des deux valeurs selon la valeur du signe. A l'aide de deux multiplexeurs, il est possible de sortir simultanément le minimum et le maximum. Les deux autres données C et D entrent dans un bloc 312 semblable au bloc 311. Leurs deux sorties entrent dans un bloc 313 qui effectue le même traitement que les blocs 311 et 312 et qui délivre le résultat de l'opération entre les quatre données A, B, C, D. Pour effectuer le tri sur l'ensemble d'une fenêtre il suffit de répéter le schéma du module 31 une fois et de lui fournir les 4 résultats intermédiaires obtenus sur 4 colonnes consécutives par le module 31 à condition d'avoir mémorisé au préalable dans 3 registres 3 de ces 4 résultats. Le traitement sur plusieurs fenêtres s'effectue selon le schéma de la figure 3 déjà décrit. Ainsi les opérateurs série effectuent une opération de tri parmi les éléments des images locales délimitées.

Le convolueur série et le circuit de tri série qui viennent d'être décrits constituent des exemples d'application et l'homme du métier peut en concevoir d'autres sans sortir du cadre de l'invention.

**Revendications**

1. Circuit intégré de traitement de signaux numérisés représentatifs d'une image source définie par des éléments d'image, codés sur M bits, disposés selon I lignes et J colonnes, le traitement de cette image source s'opérant en prélevant pas à pas des images locales délimitées par une fenêtre N.P de N lignes et de P colonnes, avec N supérieur à 1, qui glisse pas à pas à chaque élément d'image le long des I lignes de l'image source, pour couvrir l'ensemble des configurations pour lesquelles la fenêtre ne s'étend pas à l'extérieur de l'image source, caractérisé en ce que le traitement est effectué simultanément sur S images locales délimitées par S fenêtres glissantes ayant toutes les mêmes dimensions mais décalées les unes des autres de d lignes de l'image source, avec 1≦d≦N-1, et lorsque les S fenêtres glissantes ont atteint la fin de leurs lignes respectives, elles se déplacent toutes en bloc pour recommencer le même traitement, ce traitement étant effectué par des opérateurs série agissant successivement sur chaque bit de chacun de N + (S-1)d éléments d'image dont les signaux numérisés sont introduits en série dans le circuit intégré à l'aide de Q plots de contact, où Q est égal au nombre de lignes traitées en combinaison par les S images locales, chacun des Q plots de contact recevant les signaux numérisés en provenance d'un élément d'image déterminé.

2. Circuit intégré de traitement de signaux numérisés représentatifs d'une image source définie par des éléments d'image, codés sur M bits, disposés selon I lignes et J colonnes, le traitement de cette image source s'opérant en prélevant pas à pas des images locales délimitées par une fenêtre N.P de N lignes et de P colonnes, avec N supérieur à 1, qui glisse pas à pas à chaque élément d'image le long des I lignes de l'image source, pour couvrir l'ensemble des configurations pour lesquelles la fenêtre ne s'étend pas à l'extérieur de l'image source, caractérisé en ce que le traitement est effectué simultanément sur S images locales délimitées par S fenêtres glissantes ayant toutes les mêmes dimensions mais décalées les unes des autres de d lignes de l'image source, avec 1≦d≦N-1, et lorsque les S fenêtres glissantes ont atteint la fin de leurs lignes respectives, elles se déplacent toutes en bloc pour recommencer le même traitement, ce traitement étant effectué par des opérateurs série agissant successivement sur chaque bit de chacun de N + (S-1)d éléments d'image dont les signaux numérisés sont introduits en parallèle dans le circuit intégré à l'aide de Q plots de contact où Q est le premier multiple de M qui égale ou sinon majore N + (S-1)d, le circuit intégré comprenant en outre un circuit de transformation parallèle/série.

3. Dispositif de traitement d'image selon la revendication 2, caractérisé en ce qu'il comprend r mémoires d'images (avec Q = r.M) qui délivrent les données d'entrée.

4. Dispositif de traitement d'image selon une des revendications 1 à 3 caractérisé en ce que le paramètre S est égal au nombre M de bits.

5. Circuit intégré selon la revendication 4 caractérisé en ce que Q = 16, les éléments d'image étant codés sur 8 bits (M = 8) et traités par une fenêtre comprenant 9 lignes (N = 9).

6. Circuit intégré selon une des revendications 1 à 5, caractérisé en ce que les opérateurs série effectuent une convolution entre les signaux numérisés des éléments des images locales et une matrice de N.P coefficients stockés dans une mémoire.

7. Circuit intégré selon une des revendications 1 à 5, caractérisé en ce que les opérateurs série effectuent une opération de tri parmi les éléments des images locales délimitées.

FIG.1

FIG.2A

FIG.2B

FIG.3

FIG.4A

ADi    D                    ADO

CS1    M₁                   → D₁

CS2    M₂                   → D₂

FIG.4B

ADi    10                   ADO

CS₁    L1
       L1+r
       L1+2r    M₁          D₁

CS₂    L2
       L2+r
       L2+2r    M₂          D₂

CSr    Lr
       Lr+r
       Lr+2r    Mr          Dr

FIG.4C

FIG.5

EP 0 350 121 A1

4-Ⅴ-PHF 88-571

FIG.6

EP 0 350 121 A1

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| Y | EP-A-0 189 943 (HITACHI)<br>* Page 4, lignes 4-14; page 11, ligne 18 - page 13, ligne 3 *<br>--- | 1-3,6 | G 06 F 015/68 |
| Y | ELECTRONIC DESIGN, vol. 32, 4 octobre 1984, pages 209-215, Waseca, Minn., US; T. FUKUSHIMA: "Image signal processor computes fast enough for gray-scale video"<br>* Résumé *<br>----- | 1-3,6 | |

DOMAINES TECHNIQUES RECHERCHES (Int. Cl.5)

G 06 F 15/68L

Le présent rapport a été établi pour toutes les revendications

| Lieu de la recherche | Date d'achèvement de la recherche | Examinateur |
|---|---|---|
| LA HAYE | 10-10-1989 | BURGAUD C. |